# EUROPEAN PATENT SPECIFICATION

(11) **EP 3 486 214 B1**
(45) Date of publication and mention of the grant of the patent: **31.03.2021**
(21) Application number: 17827054.2
(22) Date of filing: 17.07.2017
(51) Int. Cl.: C01B 32/194, C23C 14/34, B82Y 40/00

(54) **METHOD FOR OBTAINING A GRAPHENE COVALENTLY FUNCTIONALISED WITH AN ORGANIC MOLECULE**
VERFAHREN ZUR GEWINNUNG EINES MIT EINEM ORGANISCHEN MOLEKÜL KOVALENT FUNKTIONALISIERTEN GRAPHENS
PROCÉDÉ D'OBTENTION D'UN GRAPHÈNE FONCTIONNALISÉ COVALENT AVEC UNE MOLÉCULE ORGANIQUE

(30) Priority: 15.07.2016 ES 201630971
(43) Date of publication of application: 22.05.2019
(73) Proprietor: Consejo Superior de Investigaciones Científicas (CSIC), 28006 Madrid (ES)
(72) Inventor: ACEITUNO BUENO, Rebeca, 28049 Madrid (ES); MARTÍNEZ RUIZ, José Ignacio, 28049 Madrid (ES); LUCCAS, Roberto Fabián, 28049 Madrid (ES); LÓPEZ FAGÚNDEZ, María Francisca, 28049 Madrid (ES); MOMPEÁN GARCÍA, Federico, 28049 Madrid (ES); GARCÍA HERNÁNDEZ, Mª del Mar, 28049 Madrid (ES); MARTÍN GAGO, José Ángel, 28049 Madrid (ES)
(74) Representative: Pons
(86) International application number: PCT/ES2017/070518
(87) International publication number: WO 2018/011453

(56) References cited:
- WO-A2-2005/050757
- HONGTAO WANG ET AL: "Doping Monolayer Graphene with Single Atom Substitutions", NANO LETTERS, vol. 12, no. 1, 11 January 2012 (2012-01-11), pages 141-144, XP055650128, US ISSN: 1530-6984, DOI: 10.1021/nl2031629 -& Hongtao Wang ET AL: "Supporting Online Material: Doping Monolayer Graphene with Single Atoms", , 2 December 2011 (2011-12-02), pages 1-18, XP055650281, DOI: 10.1021/nl2031629 Retrieved from the Internet: URL:https://pubs.acs.org/doi/suppl/10.1021 /nl2031629/suppl_file/nl2031629_si_001.pdf [retrieved on 2019-12-06]
- GIRJESH DUBEY ET AL: "Chemical Modification of Graphene via Hyperthermal Molecular Reaction", JOURNAL OF THE AMERICAN CHEMICAL SOCIETY, vol. 136, no. 39, 19 September 2014 (2014-09-19), pages 13482-13485, XP055650253, ISSN: 0002-7863, DOI: 10.1021/ja5046499
- HU LI ET AL: "Site-selective local fluorination of graphene induced by focused ion beam irradiation", SCIENTIFIC REPORTS, vol. 6, no. 1, 29 January 2016 (2016-01-29), XP055650257, DOI: 10.1038/srep19719
- SHU NAKAHARAI ET AL: "Conduction Tuning of Graphene Based on Defect-Induced Localization", ACS NANO, vol. 7, no. 7, 23 July 2013 (2013-07-23), pages 5694-5700, XP055650260, US ISSN: 1936-0851, DOI: 10.1021/nn401992q
- GAWLIK GRZEGORZ ET AL.: 'Ion beam induced defects in CVD graphene on glass' SURFACE AND COATINGS TECHNOLOGY vol. 306, 17 May 2016, ISSN 0257-8972 pages 119 - 122, XP029785369
- AHLGREN E H ET AL.: 'Structural manipulation of the graphene/metal interface with Ar+ irradiation' PHYSICAL REVIEW B (CONDENSED MATTER AND MATERIALS PHYSICS vol. 88, no. 15, 15 October 2013, ISSN 1098-0121 pages 1 - 6, XP055459202
- AHLBERG, P. ET AL.: 'DEFECT FORMATION IN GRAPHENE DURING LOW-ENERGY ION BOMBARDMENT' APL MATERIALS vol. 4, 12 April 2016, page 046104, XP012206795

## Description

The present invention relates to a method for obtaining a covalently functionalized graphene with an organic molecule. The method comprises a first stage of formation of defects/vacancies in the crystal lattice of a graphene, which is carried out by soft bombardment of noble gas ions under ultra-high vacuum conditions, and a second stage of exposing said graphene surface to a high partial organic molecule pressure.

Therefore, we understand that the present invention falls within the electronics and chemicals industry, particularly the industry dedicated to the manufacture of electronic devices and sensors.

### STATE OF THE ART

In recent years, graphene has emerged as a technological revolution due to, inter alia, its spectacular electron conducting and transport properties. Its multiple characterizing properties include, namely, its chemical inertia, which confers the graphene great stability and prevents contaminating molecules from adhering to its surface. However, the fact that graphene has great chemical inertia makes the functionalization of its surface a very difficult task.

It is especially important to be capable of functionalizing the graphene surface with certain molecules either to be able to manipulate the electronic properties of graphene or to use said molecules bonded to its surface as connectors for coupling other molecules with a defined mission, since said functionalization of the graphene surface would extend its use in fields such as engineering of semiconducting materials, magnetic materials with interest in spintronics and the dielectric industry, and engineering of materials such as nano-biocomposites with interest in the variation of its optical-plasmonic properties. In particular, a functionalization of the graphene surface, keeping its electron conducting and transport properties intact, would increase the technological perspectives of graphene, especially in applications in the field of electronics. Graphene functionalization is expected to be an important step in the development of graphene-based materials with tailored electronic properties.

Functionalized graphene has been extensively studied with the aim of tailoring properties for gas sensors, superconductors, supercapacitors, nanoelectronics, and spintronics. A bottleneck is the capability to control the carrier type and density by doping. It has been demonstrated that a two-step process is an efficient way to dope graphene: create vacancies by high-energy atom/ion bombardment and fill these vacancies with desired dopants. Different elements (Pt, Co, and In) have been successfully doped in the single-atom form. The high binding energy of the metal-vacancy complex ensures its stability and is consistent with in situ observation by an aberration-corrected and monochromated transmission electron microscope [HONGTAO WANG ET AL: "Doping Monolayer Graphene with Single Atom Substitutions", NANO LETTERS, vol. 12, no. 1, 11 January 2012 (2012-01-11), pages 141-144,].

Furthermore, chemical functionalization of graphene has been achieved by hyperthermal reaction with azopyridine molecular ions. The one-step, room temperature process takes place in high vacuum (10⁻⁷ mbar) using an electrospray ion beam deposition (ES-IBD) setup. For ion surface collisions exceeding a threshold kinetic energy of 165 eV, molecular cation beams of 4,4'-azobis(pyridine) covalently attach to chemical vapor deposited (CVD) graphene. A covalent functionalization degree of 3% of the carbon atoms of graphene is reached after 3-5 h of ion exposure of 2 × 10¹⁴ azopyridinium/cm² of which 50% bind covalently. This facile approach for the controlled modification of graphene extends the scope of candidate species that would not otherwise react via existing conventional methods. [GIRJESH DUBEY ET AL: "Chemical Modification of Graphene via Hyperthermal Molecular Reaction", JOURNAL OF THE AMERICAN CHEMICAL SOCIETY, vol. 136, no. 39, 19 September 2014 (2014-09-19), pages 13482-13485].

### DESCRIPTION OF THE INVENTION

The present invention relates to a method for covalently functionalizing the surface of a graphene with an organic molecule. The incorporation of organic molecules into the surface of a graphene makes it possible to modulate the electronic and optical properties of the graphene in a effective and controlled manner. The method comprises a first stage of formation of defects/vacancies in the crystal lattice of a graphene which is carried out by soft bombardment of noble gas ions under ultra-high vacuum conditions, and a second stage of exposing said graphene surface with an organic molecule.

In the first stage of the method, a density of monoatomic defects/vacancies in the crystal lattice of a graphene is created and, in a following stage of the method, organic molecules containing at least one amino group, such as for example p-aminophenol, are adsorbed on the surface of said graphene, whereupon only those molecules that penetrate the defects of the crystal lattice of the graphene are bound thereto. Specifically, the organic molecules are covalently anchored to the graphene surface through the incorporation of the N of the amino group into the vacancies/defects of the crystal lattice of the graphene. After said functionalization, the conducting properties of the initial crystalline graphene remain intact.

In a first aspect, the present invention relates to a method for obtaining a covalently functionalized graphene with an organic molecule (hereinafter, the method of the invention) comprising the following stages:
a) bombarding the surface of a system formed by graphene and a non-metal substrate with a noble gas ion beam at a pressure between 1.10⁻⁷ mbar and 1.10⁻⁸ for a period of time between 30 s and 120 s,
   wherein the system formed by graphene and a non-metal substrate is located in the interior of a chamber at an initial pressure below 1.10⁻⁹ mbar,
   wherein the energy of the noble gas ions is between 100 eV and 140 eV, and
b) optionally, thermally treating the system obtained in stage (a) at a temperature between 450°C and 550°C for a period between 5 min and 10 min,
(c) subjecting the graphene surface of stage (a) or of stage (b) to an exposure to organic molecules greater than 10 Langmuir.

In the present invention, "graphene" is understood to be graphene obtained by any of the different current graphene growth methods, such as growth in Vapor Phase Epitaxy (VPE), in Liquid Phase Epitaxy (LPE), by Molecular Beam Epitaxy (MBE) or by means of Metal-Organic Chemistry Vapor Deposition (MOCVD).

In stage (a) of the method, the surface of a system formed by a graphene and a non-metal substrate is bombarded, i.e. the graphene covering a non-metal substrate is bombarded. Non-metal substrates are chosen from among the possible substrates to prevent shielding of the graphene transport properties.

In the present invention, the graphene has grown on a non-metal substrate or has been transferred to a non-metal substrate. For example, the graphene was able to grow on a metal substrate and was subsequently transferred to a non-metal substrate.

Preferably, the graphene of stage (a) is a Single Layer Graphene (SLG) obtained by Chemical Vapor Deposition (CVD) on a non-metal substrate according to Strupinski, W. et al. "Graphene Epitaxy by Chemical Vapor Deposition on SiC." Nano Lett. 11, 1786-1791 (2011)]

Preferably, the graphene of stage (a) is quasi-free standing QFS-graphene obtained by interspersing H under the carbon layer (buffer layer), according to Tokarczyk et al. "Structural investigations of hydrogenated epitaxial graphene grown on 4H-SiC (0001)." Appl. Phys. Lett. 103, 241915 (2013).

In the present invention, "noble gas ion beam" is understood to be a beam formed of noble gas ions produced by a source of ions, selecting the source (gas) and energy of these ions. The noble gases considered in the present invention are helium (He), neon (Ne), argon (Ar), krypton (Kr) and xenon (Xe).

The method of the invention begins with a) bombarding the surface of a system formed by epitaxial graphene and a non-metal substrate with a noble gas ion beam at a pressure between 1.10⁻⁷ mbar and 1·10⁻⁸ for a period of time between 30 s and 120 s. To this end, a system formed by epitaxial graphene on a non-metal substrate is introduced in a chamber under ultra-high vacuum conditions, at a pressure below 1·10⁻⁹ mbar.

The distance from the source of the noble gas ion beam to the graphene surface depends on the dimensions of the equipment used to implement the method. In a preferred embodiment of the method of the invention, the distance from the source of the beam of said noble gas ions to the graphene surface is between 5 cm and 25 cm. More preferably, the distance is between 8 cm and 15 cm.

As mentioned earlier, the graphene is on a non-metal substrate to avoid shielding the transport properties of the graphene, preferably selecting said non-metal substrate from SiC, hBN, MoS₂, TiO₂ and SiO₂.

Furthermore, stage (a), i.e. the bombardment of the graphene surface with a noble gas ion beam is carried out with the system formed by a graphene and a non-metal substrate under ultra-high vacuum conditions, due to which said system is located in the interior of a vacuum chamber. It is a soft bombardment, i.e. the energy of the noble gas ions is between 100 eV and 140 eV.

In a preferred embodiment of the present invention, the noble gas of stage (a) is argon at a pressure of 1.10⁻⁷ mbar.

The soft bombardment with noble gas ions of the graphene surface of stage (a) induces the formation of defects/vacancies in the crystal lattice of the graphene; the formation of said graphene is activated in order to, in a subsequent stage, in stage (c) of the method, anchor organic molecules covalently to the graphene surface.

In stage (a) of the method, the formation of the aforementioned defects can be monitored by measuring the electric current produced in the system formed by a graphene and a non-metal substrate. In the present invention, the bombardment of stage (a) is soft, the electric current measured in the system is between 1 µA and 2 µA.

In the present invention, "organic molecule" is understood to be any molecule of organic origin containing at least one amino group in its structure.

Specifically, stage (a) of the method aims to anchor the organic molecules containing at least one amino group to the graphene surface. Anchoring takes place through a N of the amino group in the defects/vacancies formed in the crystal lattice of the graphene.

Preferably, the organic molecule is selected from p-aminophenol, aminothiophenol and aminobenzoic acid. Note that, for example, the p-aminophenol is bonded to the graphene surface through its amino group and not through its phenol group.

Stage b) of the method of the invention is optionally the system obtained thermally in stage (a) at a temperature between 450°C and 550°C for a period between 5 min and 10 min, for the purpose of degassing possible traces of noble gas of stage (a) on the graphene surface.

In stage (c) of the method, the surface of the system formed by a graphene and a non-metal substrate in stage (a) or in stage (b) of the method is subjected to an exposure to organic molecules greater than 10 L (Langmuir units), defined below.

Langmuir is a unit of exposure to a surface and is commonly used in ultra-high vacuum surface physics to define the adsorption of gases of said surface. The Langmuir unit is defined by multiplying the pressure of the gas by the time of exposure. One Langmuir corresponds to an exposure of 10⁻⁶ torr (1 torr = 1.33322 mbar) for one second. For example, exposing a surface to a gas pressure of 10⁻⁸ torr for 100 seconds corresponds to 1 L. Another example would be to maintain an oxygen pressure of 2.5 10⁻⁶ torr for 40 seconds, resulting in an exposure of 100 L.

Therefore, in stage (c) of the method, the surface of the system formed by a graphene and a non-metal substrate in stage (a) or in stage (b) of the method is subjected to an exposure to organic molecules greater than 10 L (Langmuir units), wherein 1 L is the product of multiplying the pressure of a gas (1.33322.10⁻⁶ mbar) by the time of exposure (1 s).

In stage (c) of the method, the system formed by graphene and a non-metal substrate, obtained in stage (a) or in stage (b) of the method, is at room temperature.

In a preferred embodiment, the method of the invention comprises the following stages:
a) bombarding the surface of a system formed by graphene and a non-metal substrate with a noble gas ion beam at a pressure between 1.10⁻⁷ mbar and 1.10⁻⁸ for a period of time between 30 s and 120 s,
   wherein the system is located in the interior of a chamber at an initial pressure of a pressure lower than 1·10⁻⁹ mbar,
   wherein the energy of the noble gas ions is between 100 eV and 140 eV,
b) thermally treating the system obtained in stage (a) at a temperature between 450°C and 550°C for a period between 5 min and 10 min, and
c) subjecting the bombarded graphene surface of stage (b) to an exposure to organic molecules greater than 10 Langmuir.

In another preferred embodiment of the method of the present invention, the graphene surface of stage (a) was previously treated thermally to degas possible pollutants physisorbed on said surface.

The thermal treatment is performed at a temperature between 200°C and 350°C for a period between 10 min and 30 min.

The covalently functionalized graphene with an organic molecule containing at least one amino group is applicable in the electronics industry, particularly in the industry dedicated to the manufacture of electronic sensors and devices.

The fact that the conducting properties of the graphene remain unaltered after the treatment is of special relevance, since the high mobility of carriers at room temperature is of special interest for their use as transistors.

Furthermore, the field effects and quantum Hall effects of the covalently functionalized graphene of the present invention are important because the carriers travel long distances without colliding with the atoms, such that said graphene can be used as part of a spintronic device.

Lastly, the good conductivity and stability of the covalently functionalized graphene of the invention is critical to applications such as electrodes for supercapacitors and other devices aimed at energy storage. The incorporation of organic molecules into the graphene surface makes it possible to modulate the electronic and optical properties of graphene in an effective and controlled manner.

In another preferred embodiment of the method of the present invention, said method also comprises an additional stage (d) of depositing metal nanoparticles on the product obtained in stage (c). Said stage (d) makes it possible to use the functionalized graphene with an organic molecule and subsequently with metal nanoparticles (the product obtained after stage (d)) in applications in the field of biosensors and optoelectronics.

In the present invention, the term "metal nanoparticles" refers to metal nanoparticles that can form a strong bond with the organic molecule anchored to the graphene surface. For example, they would be metal nanoparticles that form a strong bond with a thiol group of the organic molecule (see bond between the Au nanoparticles and the -S- of the aminothiophenol anchored to the graphene surface). Examples of said nanoparticles are Au, Ag, Cu, Pt, Rh, Fe, Co and any of their alloys.

In a more preferred embodiment of stage (d) of the method of the present invention, stage (d) is carried out by submerging the product obtained in stage (c) in a metal nanoparticle suspension. It is a simple method wherein the product obtained in stage (c), i.e. the functionalized graphene with an organic molecule, is placed in contact with a metal nanoparticle suspension after being extracted from the interior of the vacuum chamber.

In another more preferred embodiment of stage (d) of the method of the present invention, stage (d) is carried out by means of sputtering. Without having to remove the product obtained in stage (d) from the vacuum chamber, the metal nanoparticles are deposited by means of sputtering under standard conditions for depositing metal nanoparticles.

Throughout the description and the claims, the word "comprises" and its variants are not intended to exclude other technical features, additives, components or steps. For persons skilled in the art, other objects, advantages and characteristics of the invention may be inferred from both the description and the embodiment of the invention. The following examples and figures are provided by way of example and are not intended to limit the present invention.

### BRIEF DESCRIPTION OF THE FIGURES

**FIG. 1** Shows images of the surface of the system formed by a graphene and a non-metal substrate after degassing obtained using a scanning tunneling microscope (STM) at two different sizes (see scale of 2 nm (a) and 10 nm (b)).
**FIG. 2** Shows a spectrum obtained by X-ray Photoelectron Spectroscopy (XPS) of the graphene sample on SiC after the preliminary cleaning carried out to degas and clean the surface.
**FIG. 3** Shows an XPS spectrum of system 1 (a) and of system 2 (b).
**FIG. 4** Shows STM images of the defects/vacancies produced in the system after bombarding with Ar ions at two different sizes (see scale of 2 nm (a) and 3 nm (b)).
**FIG. 5** Shows STM images of the defects/vacancies produced in the system after bombarding with Ar ions.
**FIG. 6** Shows STM images of system 1 at three different sizes (see scale of 3 nm (a), 6 nm (b) and 10 nm (c)).
**FIG. 7** Shows AFM images of the graphene surface after depositing gold nanoparticles (Au) and washing them after deposition: (a) on a non-functionalized substrate (b) on a substrate activated by bombardment and functionalized with aminothiophenol.

### EXAMPLES

The invention is illustrated below by means of tests conducted by the inventors, that demonstrate the effectiveness of the product of the invention.

The graphene-on-SiC system was prepared by chemical vapor deposition on a SiC substrate and is located in the interior of a chamber with a pressure below 1.10⁻⁹ mbar.

First, the surface of the graphene-on-SiC system is cleaned by degassing the surface of said sample by means of thermal treatment at 300°C for 15 min. During preliminary degassing, the pressure inside the vacuum chamber rises considerably, indicating that pollutants that were adsorbed on the surface have been desorbed.

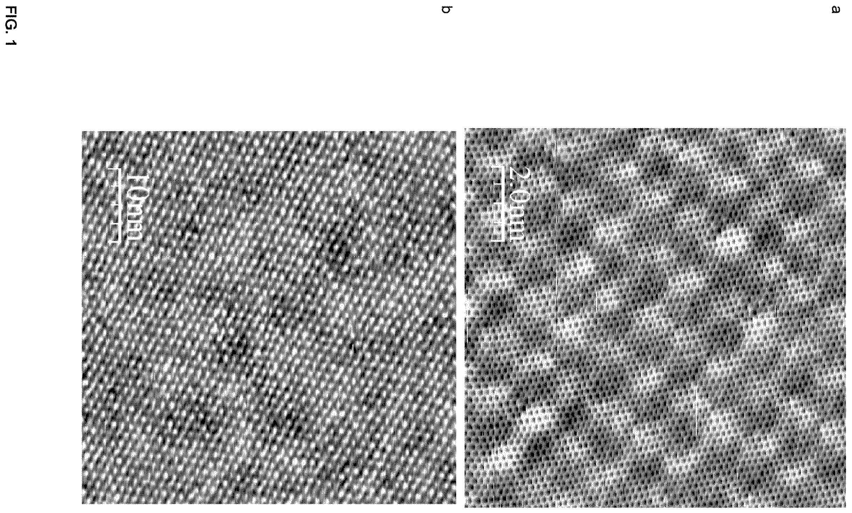

Figure 1 shows the images obtained using a scanning tunneling microscope (STM) at two different sizes (2 nm and 10 nm) corresponding to the surface of the system after previously degassing the surface. Said STM images show that the surface is clean, concluding that the pollutants were properly desorbed.

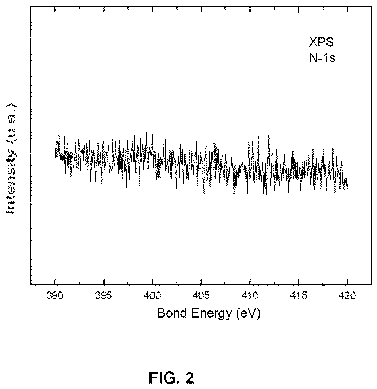

Figure 2 shows the spectrum obtained by X-ray Photoelectron Spectroscopy obtained for this system prior to the bombardment, i.e. for the degassed graphene-on-SiC surface. Said spectrum indicates that there is no presence of nitrogen on the surface.

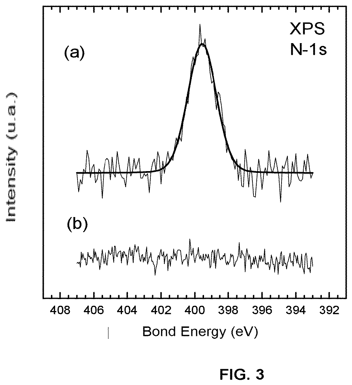

The system 1 is prepared by bombarding with Ar ions using 1.10⁻⁷ mbar and exposing the surface to a p-aminophenol flow at 10 L. Figure 3a shows the XPS spectrum for the graphene surface of the system 1, wherein the presence of nitrogen (N) is observed.

The system 2 corresponds to a system whose surface has been exposed to a p-aminophenol flow but has not been previously activated by bombarding with Ar ions. Figure 3b shows the XPS spectrum corresponding to this system. This spectrum shows that, when attempting to functionalize the graphene surface of the system 2, i.e. without having bombarded with Ar ions, p-aminophenol is not anchored to the surface of said graphene.

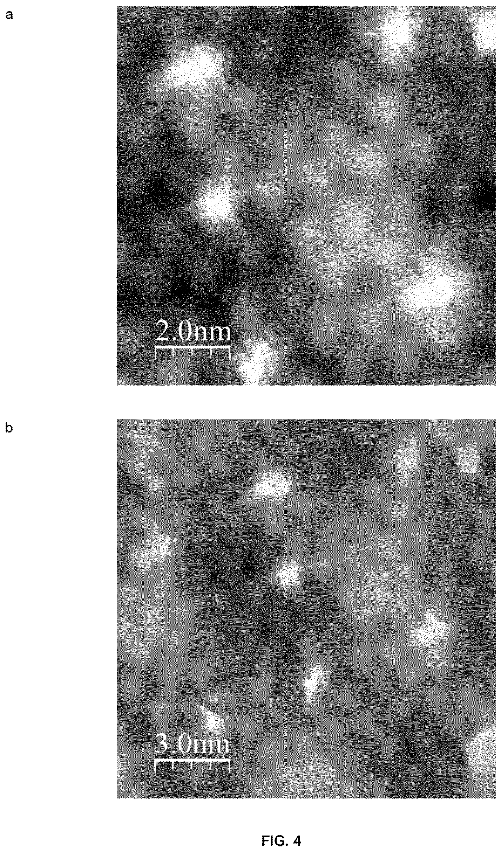

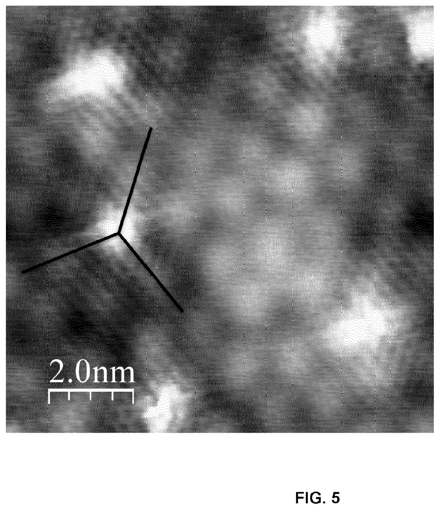

The images obtained using a tunneling-effect microscope shown in Figure 4, at two different sizes (2 nm and 3 nm), correspond to the surface of the system 1 and show the formation of defects/vacancies on the surface thereof. In Figure 5, the vacancies/defects can be observed in a peculiar manner, showing a three-axis radiation appearance, typical of these defects.

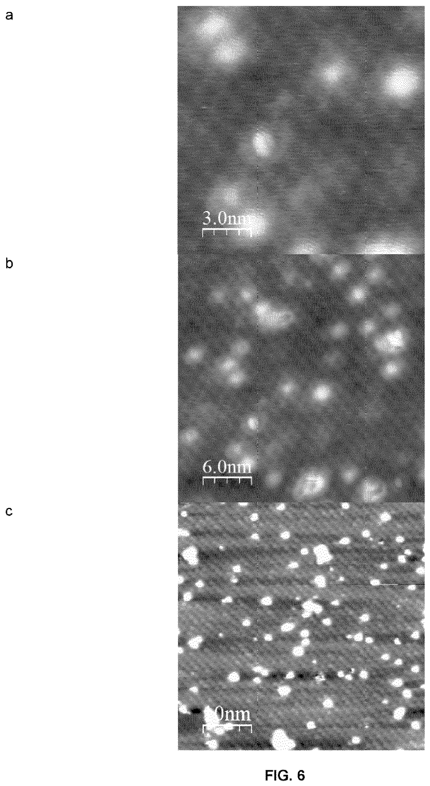

Figure 6 shows the STM images obtained for the system 1 at three different sizes (3 nm, 6 nm and 10 nm). It can be observed how the appearance of the structures on the surface is different to the images of Figures 4 and 5. The height of the nanostructures observed is greater, indicating the anchorage of the p-aminophenol molecule to the graphene surface.

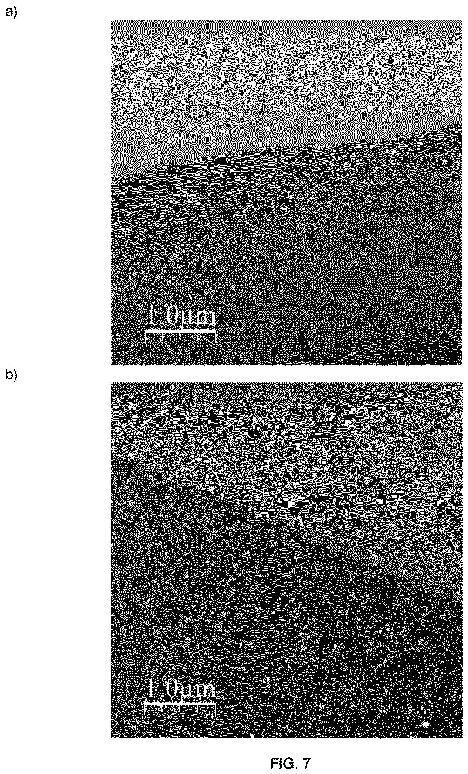

In another example, the graphene is functionalized with Au nanoparticles so they are covalently bound thereto. To this end, the following method was used: 1 cm² of a non-functionalized graphene surface (Fig. 7a) or functionalized with aminothiophenol (Fig. 7b) was introduced in a plastic tube containing 2.5 ml of Au nanoparticle suspension (at 0.1 mg Au/ml). It was left for 15 hours without any type of stirring and after that time the graphene sample was extracted from the suspension and washed with distilled water. The sample was placed on a Petri dish with 5 ml of distilled water and stirred for 15 minutes to remove all possible residues. Lastly, the sample was washed with a water jet using a Pasteur pipette and dried in an oven at 50°C for 2 hours.

Figure 7a shows the image obtained using an atomic force microscope (AFM) after depositing particles on its surface and washing them. This is the event in which the nanoparticles were deposited after submersion without activation of the surface with bombardment or functionalization with molecules. In this event, after washing, the surface has no traces of nanoparticles.

On the other hand, Figure 7b shows an AFM image of the washed self-supporting graphene-on-SiC surface wherein the activation of the graphene by bombardment, functionalization with aminothiophenol and exposure to Au nanoparticles has occurred sequentially. In this case, we have observed that the Au nanoparticles deposited and anchored by aminothiophenol resist more than 20 wash cycles and thermal treatments of at least 250°C. This example is of great relevance to applications in the field of biosensors and optoelectronics.

## Claims

1. A method for obtaining a covalently functionalized graphene with an organic molecule comprising the following stages:
a) bombarding the surface of a system formed by graphene and a non-metal substrate with a noble gas ion beam at a pressure between 1.10⁻⁷ mbar and 1.10⁻⁸ for a period of time between 30 s and 120 s,
wherein the system is located in the interior of a chamber at an initial pressure below 1·10⁻⁹ mbar,
wherein the energy of the noble gas ions is between 100 eV and 140 eV,
b) optionally, thermally treating the system obtained in stage (a) at a temperature between 450°C and 550°C for a period between 5 min and 10 min, and
c) subjecting the graphene surface of stage (a) or of stage (b) to an exposure to organic molecules greater than 10 Langmuir, wherein the organic molecule is selected from p-aminophenol, aminothiophenol and aminobenzoic acid.

2. The method, according to claim 1, wherein, in stage (a), the distance from the source of the beam of said noble gas ions to the graphene surface is between 5 cm and 25 cm.

3. The method, according to claim 2, wherein, in stage (a), the distance from the source of the beam of said noble gas ions to the graphene surface is between 8 cm and 15 cm.

4. The method, according to any of claims 1 to 3, wherein the non-metal substrate is selected from SiC, hBN, MoS₂, TiO₂ and SiO₂.

5. The method, according to any of claims 1 to 4, wherein the noble gas beam of stage (a) is argon at a pressure of 1.10⁻⁷ mbar.

6. The method, according to any of claims 1 to 5, comprising the following stages:
a) bombarding the surface of a system formed by graphene and a non-metal substrate with a noble gas ion beam at a pressure between 1.10⁻⁷ mbar and 1.10⁻⁸ for a period of time between 30 s and 120 s,
wherein the system is located in the interior of a chamber at an initial pressure below 1·10⁻⁹ mbar,
wherein the energy of the noble gas ions is between 100 eV and 140 eV,
b) thermally treating the system obtained in stage (a) at a temperature between 450°C and 550°C for a period between 5 min and 10 min, and
c) subjecting the bombarded graphene surface of stage (b) to an exposure to organic molecules greater than 10 Langmuir, wherein the organic molecule is selected from p-aminophenol, aminothiophenol and aminobenzoic acid.

7. The method, according to any of claims 1 to 6, wherein the graphene surface of stage (a) has been previously treated thermally at a temperature between 200°C and 350°C for a period between 10 min and 30 min.

8. The method, according to any of claims 1 to 7, that further comprises an additional stage (d) of depositing metal nanoparticles on the product obtained in stage (c).

9. The method, according to claim 8, wherein stage (d) is carried out by submerging the product obtained in stage (c) in a metal nanoparticle suspension.

10. The method, according to claim 8, wherein stage (d) is carried out by means of sputtering.

## Patentansprüche

1. Verfahren zum Erhalten eines kovalent funktionalisierten Graphens mit einem organischen Molekül, umfassend die folgenden Stufen:
a) Beschießen der Oberfläche eines aus Graphen und einem Nichtmetallsubstrat gebildeten Systems mit einem Edelgasionenstrahl bei einem Druck zwischen 1.10⁻⁷ mbar und 1.10⁻⁸ für einen Zeitraum zwischen 30 s und 120 s,
wobei sich das System im Inneren einer Kammer bei einem Anfangsdruck unter 1·10⁻⁹ mbar befindet,
wobei die Energie der Edelgasionen zwischen 100 eV und 140 eV beträgt,
b) wahlweise, thermisches Behandeln des in Stufe (a) erhaltenen Systems bei einer Temperatur zwischen 450° C und 550° C für einen Zeitraum zwischen 5 min und 10 min und
c) Aussetzen der Graphenoberfläche der Stufe (a) oder der Stufe (b) einer Exposition gegenüber organischen Molekülen von mehr als 10 Langmuir, wobei das organische Molekül ausgewählt ist aus p-Aminophenol, Aminothiophenol und Aminobenzoesäure.

2. Verfahren nach Anspruch 1, wobei in Stufe (a) der Abstand von der Quelle des Strahls der Edelgasionen zur Graphenoberfläche zwischen 5 cm und 25 cm beträgt.

3. Verfahren nach Anspruch 2, wobei in Stufe (a) der Abstand von der Quelle des Strahls der Edelgasionen zur Graphenoberfläche zwischen 8 cm und 15 cm beträgt.

4. Verfahren nach einem der Ansprüche 1 bis 3, wobei das NichtmetallSubstrat ausgewählt ist aus SiC, hBN, MoS₂, TiO₂ und SiO₂.

5. Verfahren nach einem der Ansprüche 1 bis 4, wobei der Edelgasstrahl von Stufe (a) Argon mit einem Druck von 1.10⁻⁷ mbar ist.

6. Verfahren nach einem der Ansprüche 1 bis 5, umfassend die folgenden Stufen:
a) Beschießen der Oberfläche eines aus Graphen und einem Nichtmetallsubstrat gebildeten Systems mit einem Edelgasionenstrahl bei einem Druck zwischen 1.10⁻⁷ mbar und 1.10⁻⁸ für einen Zeitraum zwischen 30 s und 120 s,
wobei sich das System im Inneren einer Kammer bei einem Anfangsdruck unter 1·10⁻⁹ mbar befindet,
wobei die Energie der Edelgasionen zwischen 100 eV und 140 eV beträgt,
b) thermisches Behandeln des in Stufe (a) erhaltenen Systems bei einer Temperatur zwischen 450° C und 550° C für einen Zeitraum zwischen 5 min und 10 min und
c) Aussetzen der beschossenen Graphenoberfläche von Stufe (b) einer Exposition gegenüber organischen Molekülen von mehr als 10 Langmuir, wobei das organische Molekül ausgewählt ist aus p-Aminophenol, Aminothiophenol und Aminobenzoesäure.

7. Verfahren nach einem der Ansprüche 1 bis 6, wobei die Graphenoberfläche der Stufe (a) zuvor bei einer Temperatur zwischen 200° C und 350° C für einen Zeitraum zwischen 10 min und 30 min thermisch behandelt wurde.

8. Verfahren nach einem der Ansprüche 1 bis 7, das ferner eine zusätzliche Stufe (d) zum Abscheiden von Metall-Nanoteilchen auf das Produkt umfasst, das in Stufe (c) erhalten wurde.

9. Verfahren nach Anspruch 8, wobei Stufe (d) ausgeführt wird, indem das in Stufe (c) erhaltene Produkt in eine Metall-Nanoteilchensuspension eingetaucht wird.

10. Verfahren nach Anspruch 8, wobei Stufe (d) mittels Sputterns ausgeführt wird.

## Revendications

1. Procédé d'obtention d'un graphène fonctionnalisé de manière covalente avec une molécule organique comprenant les étapes suivantes :
a) bombarder la surface d'un système formé de graphène et d'un substrat non métallique avec un faisceau d'ions de gaz rare à une pression comprise entre 1.10⁻⁷ mbar et 1.10⁻⁸ pendant un laps de temps compris entre 30 s et 120 s,
dans lequel le système est situé à l'intérieur d'une chambre à une pression initiale inférieure à 1.10⁻⁹ mbar,
dans lequel l'énergie des ions de gaz rare est comprise entre 100 eV et 140 eV,
b) optionnellement, traiter thermiquement le système obtenu à l'étape (a) à une température comprise entre 450 °C et 550 °C pendant un laps de temps compris entre 5 min et 10 min, et
c) soumettre la surface du graphène de l'étape (a) ou de l'étape (b) à une exposition à des molécules organiques supérieures à 10 Langmuir, dans lequel la molécule organique est choisie parmi le p-aminophénol, l'aminothiophénol et l'acide aminobenzoïque.

2. Procédé, selon la revendication 1, dans lequel, à l'étape (a), la distance de la source du faisceau desdits ions de gaz rare à la surface du graphène est comprise entre 5 cm et 25 cm.

3. Procédé, selon la revendication 2, dans lequel, à l'étape (a), la distance de la source du faisceau desdits ions de gaz rare à la surface du graphène est comprise entre 8 cm et 15 cm.

4. Procédé, selon l'une quelconque des revendications 1 à 3, dans lequel le substrat non métallique est choisi parmi SiC, hBN, MoS₂, TiO₂ et SiO₂.

5. Procédé, selon l'une quelconque des revendications 1 à 4, dans lequel le faisceau de gaz rare de l'étape (a) est de l'argon à une pression de 1·10⁻⁷ mbar.

6. Procédé, selon l'une quelconque des revendications 1 à 5, comprenant les étapes suivantes :
a) bombarder la surface d'un système formé de graphène et d'un substrat non métallique avec un faisceau d'ions de gaz rare à une pression comprise entre 1.10⁻⁷ mbar et 1.10⁻⁸ pendant un laps de temps compris entre 30 s et 120 s,
dans lequel le système est situé à l'intérieur d'une chambre à une pression initiale inférieure à 1.10⁻⁹ mbar,
dans lequel l'énergie des ions de gaz rare est comprise entre 100 eV et 140 eV,
b) traiter thermiquement le système obtenu à l'étape (a) à une température comprise entre 450 °C et 550 °C pendant un laps de temps compris entre 5 min et 10 min, et
c) soumettre la surface du graphène bombardée de l'étape (b) à une exposition à des molécules organiques supérieures à 10 Langmuir, dans lequel la molécule organique est choisie parmi le p-aminophénol, l'aminothiophénol et l'acide aminobenzoïque.

7. Procédé, selon l'une quelconque des revendications 1 à 6, dans lequel la surface du graphène de l'étape (a) a été préalablement traitée thermiquement à une température comprise entre 200 °C et 350 °C pendant un laps de temps compris entre 10 min et 30 min.

8. Procédé, selon l'une quelconque des revendications 1 à 7, qui comprend en outre une étape supplémentaire (d) de dépôt de nanoparticules métalliques sur le produit obtenu à l'étape (c).

9. Procédé, selon la revendication 8, dans lequel l'étape (d) est effectuée par immersion du produit obtenu à l'étape (c) dans une suspension de nanoparticules métalliques.

10. Procédé, selon la revendication 8, dans lequel l'étape (d) est effectuée au moyen d'une pulvérisation.
